# EUROPEAN PATENT APPLICATION

(11) **EP 1 995 766 A2**
(43) Date of publication of application: **26.11.2008**
(21) Application number: 08156484.1
(22) Date of filing: 19.05.2008
(51) Int. Cl.: H01L 21/00

(54) **Controlled annealing method**

(30) Priority: 20.05.2007 US 751027
(71) Applicant: Applied Materials, Inc., Santa Clara, CA 95054 (US)
(72) Inventor: Ranish, Joseph M., San Jose, CA 95117 (US); Ramachandran, Balasubramanian, Santa Clara, CA 95051 (US); Jallepally, Ravi, Santa Clara, CA 95051 (US); Ramamurthy, Sundar, Fremont, CA 94538 (US); Achutharaman Vedapuram S., Saratoga, CA 95070 (US); Haas, Brian, San Jose, CA 95123 (US); Hunter, Aaron, Santa Cruz, CA 95060 (US); Aderhold, Wolfgang, Cupertino, CA 95014 (US)
(74) Representative: Zimmermann & Partner

(57) **Abstract**

A method for rapid thermal annealing is disclosed. As the substrate is inserted into an annealing chamber, it begins to heat due to the heat radiating from chamber components that were heated when a previous substrate was annealed. Thus, the leading edge of the substrate may be at an elevated temperature while the trailing edge of the substrate may be at room temperature while the substrate is inserted causing a temperature gradient is present across the substrate. Once the substrate is completely inserted into the annealing chamber, the temperature gradient may still be present. By compensating for the temperature gradient across the substrate, the substrate may be annealed uniformly.

## Description

### BACKGROUND OF THE INVENTION

### Field of the Invention

The present invention relates generally to the field of semiconductor processing and, more specifically, to thermal annealing during semiconductor device fabrication. Further, the present invention concerns an annealing method.

### Description of the Related Art

Rapid thermal processing (RTP) is a process for annealing substrates during semiconductor fabrication. During this process, thermal radiation is used to rapidly heat a substrate in a controlled environment to temperatures of over nine hundred degrees above room temperature. The temperature may be maintained for anywhere from less than one second to several minutes, depending on the process. The substrate is then cooled to room temperature for further processing. High intensity tungsten or halogen lamps are used as the source of thermal radiation. Conductively coupling the substrate to a heated susceptor provides additional heat.

The semiconductor fabrication process has several applications of RTP. Such applications include thermal oxidation (a substrate is heated in oxygen or a combination of oxygen and hydrogen which causes the silicon substrate to oxidize to form silicon dioxide); high temperature soak anneal (different gas mixtures such as nitrogen, ammonia, or oxygen are used); low temperature soak anneal (to anneal substrates deposited with metals); and spike anneal (used in processes where the substrate needs to be exposed to high temperatures for a very short time).

During annealing, the substrate is heated using thermal radiation from an array of lamps. The substrate may be heated at a ramp rate of up to 250 degrees Celsius/sec to temperatures greater than 1000 degrees Celsius. The substrate is then cooled by conductively coupling the hot substrate to a cold reflector plate using a blanket of inert gas such as helium gas. This forced cooling facilitates a faster cooling rate, achieving ramp down rates of up to 80 degrees Celsius/sec.

The object of annealing is a substantially uniform temperature profile across the substrate. High ramp up and ramp down rates require improved methods for controlling uniformity during an annealing process.

### SUMMARY OF THE INVENTION

In light of the above, the annealing method according to independent claim 1, the annealing method according to independent claim 7, and the annealing method according to independent claim 12 are provided.

Further advantages, features, aspects and details are evident from the dependent claims, the description and the drawings.

The present invention generally provides a method for rapid thermal annealing. By controlling the power to a plurality of arrays and/or lamps within the chamber based upon real-time substrate temperature measurements, uniform annealing occurs. In one embodiment, an annealing method comprises detecting a temperature variation on a substrate positioned under a plurality of lamps within a chamber and annealing the substrate by controlling an amount of heat emitted from each lamp as a function of the detected temperature variation such that the annealing achieves a uniform temperature across the substrate.

In another embodiment, an annealing method comprises detecting a substrate having a non-uniform temperature in at least one non-radial direction under a plurality of lamps within a chamber, at least a portion of the substrate positioned on an edge ring and annealing the substrate by controlling the amount of heat emitted from the lamps such that a disproportionate amount of heat is applied to the appropriate regions so as to achieve a uniform temperature across the substrate.

In yet another embodiment, an annealing method comprises creating a temperature gradient across a substrate as the substrate is inserted into a chamber and annealing the substrate by controlling an amount of heat emitted from each of a plurality of lamps positioned within the chamber above the substrate as a function of the temperature gradient such that the annealing achieves a uniform temperature across the substrate.

Further, an apparatus for annealing a substrate is provided, comprising a chamber, in particular an RTP chamber, having a plurality of lamps for irradiating the substrate and supporting means for the substrate. Further the apparatus may comprise in an embodiment a reflective surface in the chamber. The reflective surface may be disposed below a substrate inserted into the chamber. The apparatus may further comprise in a typical embodiment at least one sensor and/or a controller, in particular connected to at least one sensor, wherein the controller is adapted for detecting a temperature variation on the substrate and to anneal the substrate by controlling an amount of heat emitted from each lamp as a function of the detected temperature variation such that the annealing achieves a uniform temperature across the substrate.

The apparatus may have in one embodiment a two dimensional array of lamps.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

In one aspect of the invention, a method for rapid thermal annealing is disclosed. As the substrate is inserted into an annealing chamber, it begins to heat due to the heat radiating from chamber components that were heated when a previous substrate was annealed. Thus, the leading edge of the substrate may be at an elevated temperature while the trailing edge of the substrate may be at room temperature while the substrate is inserted causing a temperature gradient is present across the substrate. Once the substrate is completely inserted into the annealing chamber, the temperature gradient may still be present. By compensating for the temperature gradient across the substrate, the substrate may be annealed uniformly.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a vertical sectional view of a portion of an RTP chamber according to one embodiment of the present invention.

Figure 2 is a partial view of a bottom surface of a lid assembly of an RTP chamber that utilizes an array of lamps.

Figure 3 is a partial view of the bottom surface of the lid assembly of Figure 2 with the array of lamps removed.

Figure 4 is a flow chart illustrating an annealing process according to one embodiment of the invention.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments of the present invention disclosed below may be practiced in a RADIANCE^{™} chamber or a VANTAGE^{™} RadiancePlus RTP chamber, both of which are available from Applied Materials, Inc., Santa Clara, California. It is contemplated that the methods described herein may be practiced in other suitably adapted chambers, including those from other manufacturers.

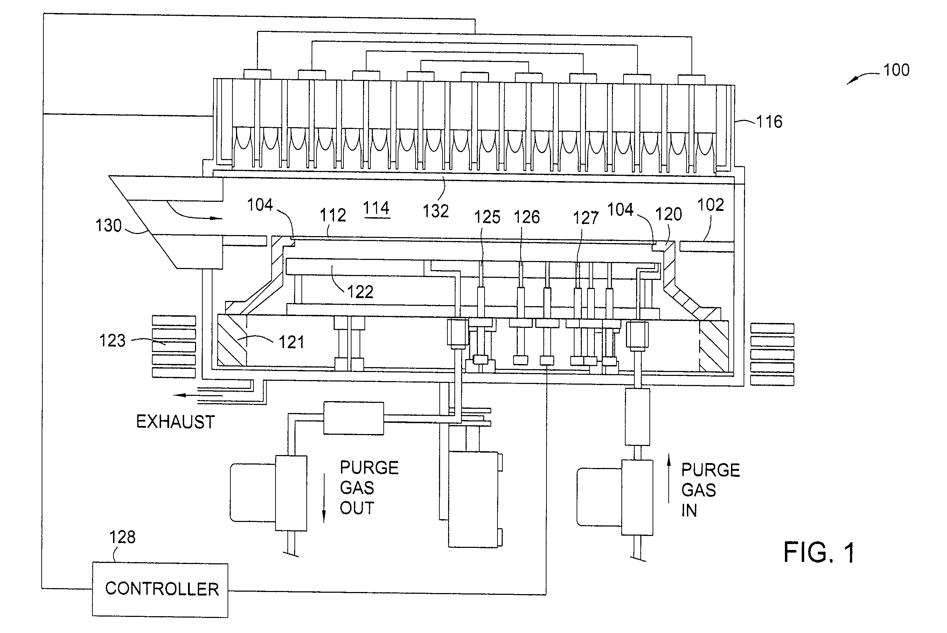

Figure 1 illustrates a substrate 112 supported in a modified RTP chamber 100 having an array of lamps 116 disposed behind a window 132. In one embodiment, the window 132 may be a quartz window. In another embodiment, the window 132 may be made of a transmissive material. In one embodiment, the lamps 116 may emit radiation in the infrared region. In another embodiment, the lamps 116 may emit radiation in the near-infrared region. In yet another embodiment, the lamps 116 may comprise tungsten halogen lamps. The substrate 112 rests on an edge ring 120 with a gap 104 between the edge ring 120 and the substrate 112 to facilitate placement of the substrate 112 onto the edge ring 120 and removal of the substrate 112 from the edge ring 120. A controller 128 receives measurements from pyrometers 125, 126, and 127 to output control signals to lamps 116.

A reflective surface 122 disposed below the substrate 112 has openings for purge gas lines, lift pins, and sensors (not shown). The location of the openings and flow of purge gas may be configured to facilitate control of the temperature profile of the substrate. Additional control of substrate non-uniformity is provided if the reflective surface 122 does not rotate. In one embodiment, the reflective surface 122 may be rotated. A stationary reflective surface 122 facilitates localized gas jet cooling and lamp adjustments.

Alternatively, the substrate 112 may be magnetically rotated by an actuator 123 that rotates a rotor 121. The actuator 123 is magnetically coupled to the rotor 121. In one embodiment, the actuator 123 may be adapted to change the elevation of the rotor 121 and/or to adjust the angular orientation of the rotor 121 relative to its central axis. A first elevation of the rotor 121 places the substrate 112 in a transfer position 114 for removal of the substrate through a slit valve 130. A new substrate is then positioned by the rotor 121 for annealing. A cover 102 may protect the rotor 121 from undue heating during the annealing process.

In another embodiment, a robot blade may enter the chamber 100 where lift pins may elevate to lift the substrate 112 off of the robot blade. The robot blade may then retract and the slit valve 130 may close. The substrate 112 may be conductively heated by the lift pins. The lift pins may then lower the substrate 112 onto the edge ring 120.

The reflective surface 122 may be modified to improve the chamber's temperature tailoring capabilities. The reflective surface 122 may have openings for one or more pyrometers 125, 126, and 127. The reflective surface 122 may additionally comprise a gas distribution inlet and outlet. Ejecting gas through holes (not shown) in the reflective surface 122 may help speed cooling because a hole does not reflect energy back to the substrate 112. Tailoring the design of the holes in the reflective surface 122 may provide another mechanism to facilitate heat transfer. A rapid thermal anneal system such as the embodiment illustrated by Figure 1 may also include a laser for annealing such as the laser annealing system described in United States Patent Publication No. 2005/0186765 A1 which is hereby incorporated by reference.

Ordinarily, the lamps 116 and reflective surface 122 are designed to produce a relatively uniform irradiance on the substrate. This irradiance distribution can be arbitrarily adjusted with radial symmetry by deliberately altering the offset temperatures. Placing the lamps 116 off center is desirable for heat distribution and for better convection for substrate 112 cooling. Also, radial locations on the substrate 112 where higher temperatures are desired could have the corresponding lamp 116 locations comprised of higher power lamps 116, while other locations can be comprised of lower power lamps 116, or in some locations the lamps 116 may be removed. Where increased temperature gradients are required, reflective surfaces 112 producing narrower beams upon reflection could be used to decrease the radiation spread from one control zone to another. Additionally, light emitting diodes (LEDs) may be disposed within the chamber to provide additional temperature control. Alternatively, the lamps 116 may be replaced with LEDs.

The chamber may also be engineered to radiate additional power through certain lamps 116 or certain zones of lamps 116. This additional power may be used to tailor the temperature profile on the substrate 112 as desired. If the substrate 112 were rotating with respect to the lamp 116 head, then these engineered temperature profiles would mainly consist of non-uniform temperature profiles along the radius of the substrate. Radial locations where non-uniformity is desired could have the corresponding lamps increase or decrease in power as desired. Altering the lamp 116 parameters could be used to compensate for the difference in edge temperature range effect caused by substrates 112 of different emissivities.

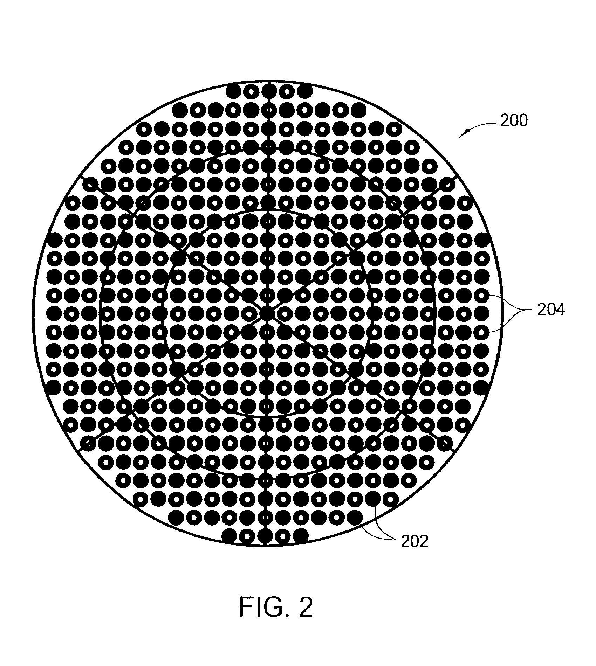

Figure 2 shows a partial view of a bottom surface 200 of a lid assembly that utilizes an array of lamps 202. While many individual bulbs are depicted, the array of lamps 202 may include as few as two bulbs powered by a single power source or separate power sources. For example, the array of lamps 202 in one embodiment includes a first bulb for emitting a first wavelength distribution and a second bulb for emitting a second wavelength distribution. The annealing process may thus be controlled by defining various sequences of illumination with the various lamps 202 within a given annealing chamber in addition to adjustments in gas flows, composition, pressure, and substrate temperature.

The lamps 202 may be arranged in zones or regions across the array of lamps. The zones may extend radially out from the center of the substrate or may be arranged in sections across the diameter of the substrate. For example, the zones may be selected to target more heat to the circumference of the substrate or to provide bulbs with different spectrum for the substrate to be exposed to as the substrate rotates. The bulb placement may influence the resulting substrate properties more markedly when the substrate is not rotated.

The array of lamps 202 can be designed to meet specific UV spectral distribution requirements by selecting and arranging one, two, or more different types of individual bulbs within the array of lamps 202. For example, bulbs may be selected from low pressure Hg, medium pressure Hg, and high pressure Hg.

The array of lamps 202 can utilize highly efficient bulbs such as UV light emitting diodes. UV sources powered by microwave or pulsed sources have a conversion efficiency of five percent compared to low power bulbs, such as 10W-100W, that can be in the array of lamps 202 to provide a conversion efficiency of about twenty percent. With the microwave power source ninety five percent of the total energy is converted to heat that wastes energy and necessitates extra cooling requirements while only five percent of the energy is converted to UV emission. The low cooling requirement of the low power bulbs can allow the array of lamps 202 to be placed closer to the substrate (e.g., between one and six inches) to reduce reflected UV light and loss of energy.

Furthermore, the bottom surface 200 of the lid assembly may include a plurality of gas outlets 204 interleaved within the array of lamps 202. Accordingly, processing gases may be introduced into a process region within a chamber from above. Additional detailed information may be obtained from United States Patent Publication No. 2006/0251827 A1, which is hereby incorporated by reference.

Referring again to Figure 1, during processing, the lamps 116 may heat the substrate 112 to a high temperature as described above. The annealing heats not only the substrate 112, but the various chamber components as well, including the quartz window 132 that separates the lamps 116 from the processing area of the chamber 100. A substrate 112 entering the chamber 100 may be initially at room temperature. As the substrate 112 passes through the slit valve 130 into the chamber 100, the leading edge of the substrate 112 may begin to heat due to the proximity of the substrate 112 to the quartz window 132. Thus, as the substrate 112 enters the chamber 100, the leading edge of the substrate 112 may have a temperature elevated above room temperature as compared to the trailing edge of the substrate 112 which is outside the processing chamber 100. Therefore, as the substrate 112 enters the chamber 100, a temperature gradient across the substrate 112 develops. By the time the substrate 112 is entirely contained within the processing chamber 100, the substrate 112 may not have a uniform temperature across the substrate 112 due to the leading edge of the substrate 112 being exposed to heated chamber 100 components for a greater amount of time as compared to the trailing edge of the substrate 112.

Additionally, when the substrate 112 is inserted into the chamber 100, the substrate 112 rests on the edge ring 120. As the edge ring 120 was heated in a previous annealing process, the edge ring 120 may retain some heat from the previous annealing process and be at a temperature greater than the substrate 112, and, thus, conductively heat the substrate 112. The portions of the substrate 112 that are in contact with the edge ring 120 may be conductively heated to a temperature greater than the portions of the substrate 112 not in contact with the edge ring 120. Therefore, a temperature gradient may exist from the edge of the substrate 112 to the center of the substrate 112. Another complication that may arise is the larger thermal mass being heated where the substrate 112 overlaps the edge ring 120. Areas where there is more overlap *(i.e.,* as a result of being placed not perfectly on center), may have lower heating rates during the ramp up to temperature relative to the areas at the same radius where the overlap is smaller. The temperature non-uniformity may not be mitigated by purely radial control zones. In the embodiment where lift pins receive the substrate 112, temperature non-uniformities may exist across the substrate 112 due to any mismatch in individual lamp 116 power and/or any non-rotation of the substrate 112.

When the substrate 112 is disposed onto the edge ring 120, the substrate 112 may not be perfectly centered on the edge ring 120. Due to the gap between the edge ring 120 and the edge of the substrate 112, the substrate 112 may be slightly off center on the edge ring 120. Additionally or alternatively, the robot may not repeatably dispose a substrate 112 onto the exact same location. Thus, the portions of the substrate 112 that rest on the edge ring 120 may not be a uniform radial distance from the center of the substrate 112. Therefore, not only may a temperature gradient exist from the edge of the substrate 112 to the center of the substrate 112, but the temperature gradient from the edge of the substrate 112 to the center of the substrate 112 may vary at each angular location around the substrate 112.

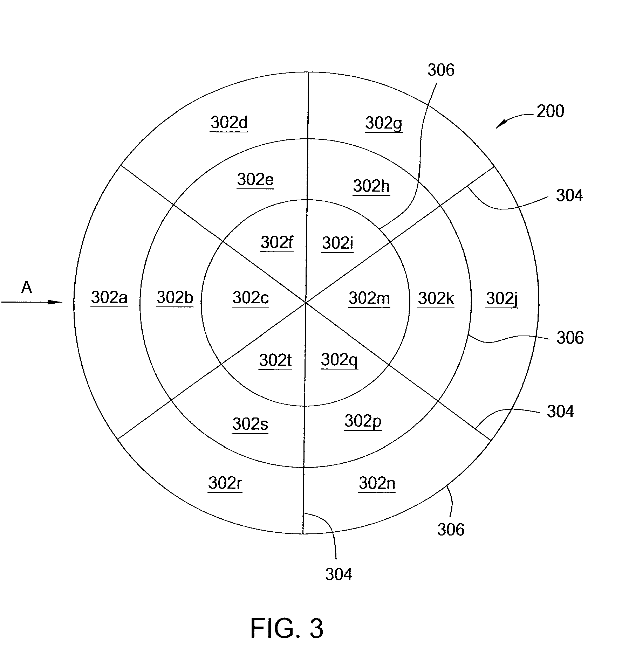

To compensate for temperature gradients across the substrate 112, the lamps may be divided into a plurality of zones (302a-k, 302m, 302n, and 302p-302t) with each zone containing one or more lamps. Figure 3 is a partial view of the bottom surface of the lid assembly of Figure 2 with the lamps removed. Each zone (302a-k, 302m, 302n, and 302p-302t) may be defined by boundaries 304, 306. The lamps within each zone (302a-k, 302m, 302n, and 302p-302t) may be collectively powered or, to provide even greater control, may be individually powered within each zone (302a-k, 302m, 302n, and 302p-302t). The power applied to the zones (302a-k, 302m, 302n, and 302p-302t) and/or individual lamps may be adjusted based upon real-time feedback provided by the pyrometers. Additionally, as the substrate rotates during annealing, the power applied to the various zones (302a-k, 302m, 302n, and 302p-302t) and/or individual lamps may be adjusted to compensate for the temperature of the portion of the substrate present under the zone (302a-k, 302m, 302n, and 302p-302t) and/or lamp at any instant in time. The real-time feedback from the pyrometers permits real-time control of the power so that the power provided to the zones (302a-k, 302m, 302n, and 302p-302t) and/or individual lamps may be continuously adjusted. The control may include providing a lower or higher power or even no power to the zones (302a-k, 302m, 302n, and 302p-302t) and/or the individual lamps. Once the temperature gradient no longer exists, all the zones (302a-k, 302m, 302n, and 302p-302t) and/or all the individual lamps may be provided with the same level of power.

The lamps may be divided in two or more zones, in particular in 3 to 30 zones, typically between 6 and 27. In a further embodiment the lamps may be divided in 12 to 24 zones, typically 18 zones. In an embodiment, the zones may form sector portions, wherein in particular each sector comprises 1 to 10 sector portions, typically 2 to 6 sector portions. In a further embodiment the each sector may comprise three sector portions, in particular an inner sector portion, a middle sector portion and an outer sector portion, wherein each having a different radial distance from the center.

As depicted in Figure 3, the substrate may enter the chamber under the lid assembly in the direction shown by arrow "A". Once the substrate is positioned within the chamber, the pyrometers (see Figure 1), may measure the temperature of the substrate at various predetermined locations. The power applied to each zone (302a-k, 302m, 302n, and 302p-302t) may then be set based upon the measured temperature for the various predetermined locations. For example, because the leading edge of the substrate may be at a higher temperature as compared to the trailing edge of the substrate, zone 302a, which corresponds to the trailing edge of the substrate, may be provided with a higher power as compared to zone 302j, which corresponds to the leading edge of the substrate. The other zones (302b-l, 302k, 302m, 302n, and 302p-302t) may also be adjusted according to temperature measurements. The power to the zones (302a-k, 302m, 302n, and 302p-302t) and/or the individual lamps may be synchronized with the rotation of the substrate. The ability to control the power applied to the zones (302a-k, 302m, 302n, and 302p-302t) and/or the individual lamps compensates for temperature variations in a substrate, including variations at the same radial distance from the center of the substrate.

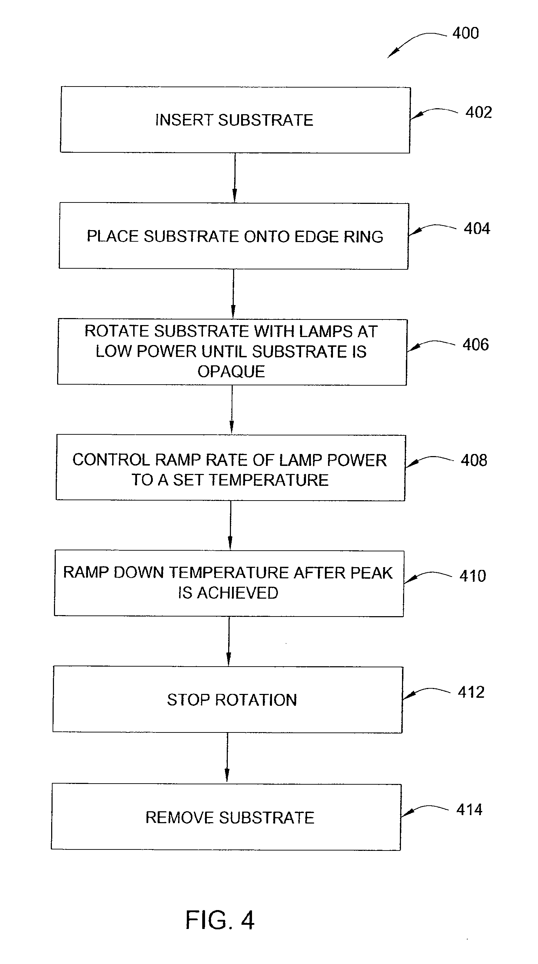

Figure 4 is a flow chart 400 illustrating an annealing process according to one embodiment of the invention. At step 402, the substrate is inserted into the chamber. As the substrate is inserted, the leading edge of the substrate may begin to be heated. At step 404, the substrate is disposed onto the edge ring. As noted above, the substrate may be disposed perfectly centered onto the edge ring or the substrate may be disposed slightly off center onto the edge ring.

At step 406, the substrate begins to rotate. As the substrate rotates, the ramp rate of the power to the lamps may be adjusted based upon temperature real-time temperature feedback for a plurality of locations across the substrate in step 408. The substrate is initially annealed at a low power until the substrate is opaque from the heat. Thereafter, the annealing temperature may be ramped up to a predetermined temperature. Following the annealing, the temperature may be ramped down (step 410) and the rotation stepped (step 412). The substrate may then be removed (step 414).

By individually controlling zones of lamps and/or individual lamps based upon real-time feedback of temperature measurements across the substrate, uniform annealing of the substrate is possible.

While the foregoing is directed to embodiments of the present invention, other and further embodiments of the invention may be devised without departing from the basic scope thereof, and the scope thereof is determined by the claims that follow.

## Claims

1. An annealing method, comprising:
detecting a temperature variation on a substrate positioned under a plurality of lamps within a chamber; and
annealing the substrate by controlling an amount of heat emitted from each lamp as a function of the detected temperature variation such that the annealing achieves a uniform temperature across the substrate.

2. The method of claim 1, further comprising:
rotating the substrate during the annealing;
wherein the detecting comprises detecting the temperature at a plurality of locations across the substrate as the substrate rotates; and
wherein the annealing comprises synchronizing the controlling of the amount of heat emitted from each lamp with the rotation of the substrate as a function of the detected temperature, wherein the controlling the amount of heat emitted comprises reducing the amount of power to one or more lamps and at least one of:
increasing the amount of power to one or more other lamps; and
maintaining the amount of power applied to the one or more other lamps.

3. The method of claim 1 or 2, wherein the temperature variation is detected at a plurality of locations on the substrate that are of equal radial distance from a center of the substrate.

4. The method according to one of the claims 1 to 3, wherein the annealing comprises applying a different amount of heat to a plurality of locations that are of equal radial distance from a center of the substrate.

5. The method of claim according to one of the claims 1 to 4, wherein two or more of the plurality of lamps are coupled together and simultaneously controlled.

6. The method according to one of the claims 1 to 5, wherein the controlling the amount of heat emitted comprises reducing the amount of power to one or more lamps and at least one of:
increasing the amount of power to one or more other lamps; and
maintaining the amount of power applied to the one or more other lamps.

7. An annealing method, comprising:
detecting a substrate having a non-uniform temperature in at least one non-radial direction under a plurality of lamps within a chamber, at least a portion of the substrate positioned on an edge ring; and
annealing the substrate by controlling the amount of heat emitted from the lamps such that a disproportionate amount of heat is applied to the appropriate regions so as to achieve a uniform temperature across the substrate.

8. The method of claim 7, further comprising:
rotating the substrate during the annealing;
wherein the detecting comprises detecting the temperature as the substrate rotates at a plurality of locations across the substrate; and
wherein the annealing comprises synchronizing the controlling of the amount of heat emitted from each lamp with the rotation of the substrate as a function of the detected temperature, wherein the controlling the amount of heat emitted comprises reducing the amount of power to one or more lamps and at least one of:
increasing the amount of power to one or more other lamps; and
maintaining the amount of power applied to the one or more other lamps.

9. The method of claim 7 or 8, further comprising:
detecting a temperature variation at a plurality of locations on the substrate that are of equal radial distance from a center of the substrate, further comprising:
rotating the substrate during the annealing, wherein the detecting of the temperature variation occurs during the rotating; and
synchronizing the controlling of the amount of heat emitted from each lamp with the rotation of the substrate as a function of the detected temperature, wherein the annealing comprises applying a different amount of heat to a plurality of locations that are of equal radial distance from a center of the substrate.

10. The method according to one of the claims 7 to 9, wherein two or more of the plurality of lamps are coupled together and simultaneously controlled.

11. The method according to one of the claims 7 to 10, wherein the controlling the amount of heat emitted comprises reducing the amount of power to one or more lamps and at least one of:
increasing the amount of power to one or more other lamps; and
maintaining the amount of power applied to the one or more other lamps.

12. An annealing method, comprising:
creating a temperature gradient across a substrate as the substrate is inserted into a chamber; and
annealing the substrate by controlling an amount of heat emitted from each of a plurality of lamps positioned within the chamber above the substrate as a function of the temperature gradient such that the annealing achieves a uniform temperature across the substrate.

13. The method of claim 12, further comprising:
rotating the substrate during the annealing;
detecting the temperature at a plurality of locations across the substrate as the substrate rotates; and
synchronizing the controlling of the amount of heat emitted from each lamp with the rotation of the substrate as a function of the detected temperature, wherein the controlling the amount of heat emitted comprises reducing the amount of power to one or more lamps and at least one of:
increasing the amount of power to one or more other lamps; and
maintaining the amount of power applied to the one or more other lamps.

14. The method of claim 12 or 13, wherein the annealing comprises applying a different amount of heat to a plurality of locations that are of equal radial distance from a center of the substrate.

15. The method according to one of the claims 12 to 14, wherein two or more of the plurality of lamps are coupled together and simultaneously controlled.
